# EUROPEAN PATENT APPLICATION

(11) **EP 3 518 301 A1**
(43) Date of publication of application: **31.07.2019**
(21) Application number: 18153309.2
(22) Date of filing: 24.01.2018
(51) Int. Cl.: H01L 51/42

(54) **CRYSTAL DEFECTS MITIGATING AGENTS FOR HIGH POWER CONVERSION EFFICIENCY AND STABILITY OF PEROVSKITE PHOTOVOLTAIC DEVICES**

(71) Applicant: Ecole Polytechnique Fédérale de Lausanne (EPFL), 1015 Lausanne (CH)
(72) Inventor: Tavakoli, Mohammad Mahdi, Cambridge, MA 02141 (US); Liu, Yuhang, 1020 Renens (CH); Zakeeruddin, Shaik Mohammed, 1030 Bussigny (CH); Graetzel, Michael, 1025 St-Sulpice (CH)
(74) Representative: Ganguillet, Cyril

(57) **Abstract**

This invention relates to an optoelectronic and/or photovoltaic device comprising a compound used as crystal defect mitigating agent or passivating agent, said compound being selected from a compound of formula (I) 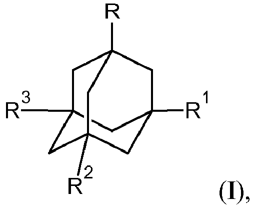 a compound of formula (II) 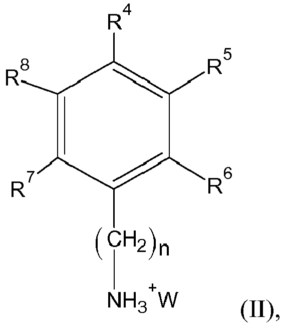 a mixture thereof, or a compound of formula (III) being a compound of formula (I), of which substituent R is substituted by one compound of formula (II) being linked to said compound of formula (I) through any one of unsubstituted R⁴, R⁵,R⁶, R⁷ or R⁸.

## Description

This invention relates to a photovoltaic device, in particular to a metal organohalide perovskite photovoltaic device, to a passivated metal organohalide perovskite photovoltaic devices or solar cells (PSCs), a method for producing passivated metal organohalide perovskite photovoltaic devices, and more specifically, to a method for passivating light absorbing layer (LAL) or hole transporting layer in organic-inorganic perovskite based photovoltaic devices.

### Prior Art and the Problem Underlying the Invention

Currently, the photovoltaics market is dominated by crystalline silicon-based solar cells. However, they have the longest energy payback time due to high manufacturing cost. Thin-film photovoltaic devices based on amorphous silicon, copper indium gallium (di)selenide (CIGS) and CdTe, are beginning to penetrate the market. Nevertheless the fabrication of inorganic thin-film solar cells typically requires high temperature and high vacuum technologies. In addition, thin film solar cells contain toxic elements, low abundance, and limit their large-scale production. On the other hand, fast progress in the field of perovskite solar cell (PSCs)has attracted tremendous attention resulting in a device with the current certified solar to electric power conversion efficiency (PCE) of 22.7%.

Due to its optical and electrical properties (large absorption coefficient, high charge carrier mobility and long diffusion length) and its low-cost and earth abundance, perovskite sensitizer ABX₃ (A: CH₃NH₃, B: Pb, Sn, and X: Cl, Br, I) represents highly promising material for thin-film photovoltaics. The band level of organic-inorganic perovskite is mostly defined by the B and X site elements. Thus, there are many options to replace main elements of perovskite materials to tune the band gap. One of the organic-inorganic halide perovskites used for photovoltaics has the general structure ABX₃ and comprises monovalent cations A = (Cs⁺, methylammonium (MA), formamidinium (FA)), a divalent metal B = (Pb²⁺), and an anion X = (Br⁻; I⁻). Perovskites comprising pure FA as cations A can crystallize as a photoinactive orthorhombic or hexagonal δ-phase at room temperature or as a photoactive perovskite α-phase ("black phase"). The induction of the crystallization of perovskite containing FA as cation A towards the black phase crystallization has been improved by mixing further cations to the pure perovskite such as small amount of MA, being considered as a "crystallizer" (or stabilizer) for the black phase of perovskite containing FA. A perovskite solar cell comprising an organic-inorganic perovskite based on a mixture of organic cations MA and FA has been demonstrated to reach an efficiency over 21.0 %. It was also demonstrated that using Cs induces a preferable crystallization of FA. Although a device comprising Cs/FA/MA perovskite presents good reproducibility and stability and high PCE (Photoelectric Conversion Efficiency), this perovskite material, suffering from small grain size due to the presence of Cs and as a result of fast nucleation, provides crystal defects into the perovskite layer of the photovoltaic device. Such defects impair the device performance.

To improve the device performance further and establish long term operational stability, innovative device architectures, interface modulation, as well as compositional and crystal growth engineering are used. One strategy to control the defect level on the surface of perovskite film is passivation. Mitigation of electronic defects plays a key role to reduce radiationless carrier recombination resulting in higher open circuit photovoltages (*V_{oc}*)*.* For this purpose, a wide variety of additives modulating or mitigating agent) has been examined, including polymers, fullerenes, metal halides, inorganic acids, co-solvents, organic halide salt, and nanoparticles. To this effect, the modulating agents are either added to the anti-solvent or the perovskite precursor solution. Thus the additives stay on top of the perovskite layer and annihilate the defects. However, during the fabrication of the device, these additives can be washed away during the spin coating of HTL (Hole Transport Layer) onto the perovskite film resulting in an inefficient passivation of said film and a decrease of the performance.

The present invention addresses the problem of the passivation of light harvesting layer, in particular organic-inorganic perovskite layer and the efficiency and the reproducibility of said passivation to increase the performance and stability of the device.

The present invention also addresses the problem of washing out of the passivation or mitigating agent during the process of fabrication of photovoltaic devices and to simplify the manufacturing process and to reduce the costs of fabrication reduction.

The present invention addresses disadvantages concerning the pure organic-inorganic perovskites: sensibility to variations during the fabrication process resulting in the decrease of the quality of the thin film of perovskite.

The present invention addresses disadvantages of photovoltaic devices comprising organic-inorganic perovskites such as low open circuit voltage (V_{oc}), thermal instability, high loss of efficiency in full illumination under the long-term (aging problem), and low light sensitivity.

The present invention addresses the problems depicted above.

### Summary of the Invention

Remarkably, in some aspects, the present inventors have found that compounds selected from adamantane derivatives and/or benzylamino hydroiodide derivatives, in particular alkyl or heteroalkyl benzylamino hydroiodide, can be used as crystal defect mitigating agent or passivation agent in photovoltaic devices, and in particular in photovoltaic devices comprising organic-inorganic perovskite or metal organohalide perovskite to improve the efficiency and stability of the device. The inventors have also found a method for passivating the light-harvesting layer comprising metal organohalide perovskite material. The method can efficiently passivate different type of metal organohalide perovskite materials by avoid washing out and may reduce the number of fabrication steps of the device resulting in time and cost saving.

Surface modification or passivation of perovskite films by adamantane derivatives and/or alkylbenzylamino hydroiodide leads to mitigate defect states of crystal and to extend the photoluminescence lifetime of the perovskite films, and to attenuate surface states acting as sites for non-radiative charge carrier recombination. The passivation of perovskite films by said compounds enhances the stability of the photovoltaic device and in particular the perovskite solar cell.

According to one aspect, the present invention provides an optoelectronic and/or photovoltaic device comprising a compound used as crystal defect mitigating agent or passivating agent, said compound being selected from a compound of formula (I) 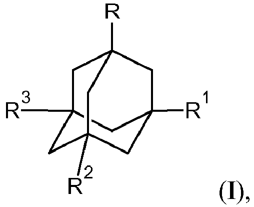 a compound of formula (II) 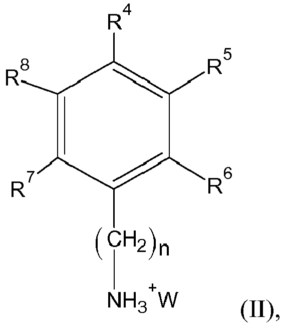 a mixture thereof, or
a compound of formula (III) being a compound of formula (I), of which substituent R is substituted by one compound of formula (II) being linked to said compound of formula (I) through any one of unsubstituted R⁴, R⁵, R⁶, R⁷ or R⁸, and wherein the substituent R⁴, R⁵, R⁶, R⁷ or R⁸ not being linked are independently selected from any substituent as defined below,
wherein
R, R¹, R², R³, R⁴, R⁵, R⁶, R⁷ and R⁸ are independently selected from H, -NH₂, -NCS, - CN, - NCO, -NH₃⁺, -NH₃⁺Y, -R⁹, -NHR⁹, -NR⁹R¹⁰, -O-R⁹, -S-R⁹, or halogen being selected from F, Cl, Br or I, wherein R⁹ and R¹⁰ are independently selected from C6-C15 aryl, C6-C15 heteroaryl, C3-C15 cycloalkyl group, C3-C15 heterocycloalkyl groups, C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein aryl, heteroaryl, cycloalkyl, heterocycloalkyl, alkyl, heteroalkyl, alkenyl, alkynyl group are unsubstituted or further substituted by halogen being selected from F, Cl, Br or I,
Y and W are independently selected from F⁻, Cl⁻, Br⁻, I⁻, SCN⁻, BF₄⁻, PF₆⁻, ClO₄⁻, N(SO₂CF₃)₂⁻, N(SO₂CF₂CF₃)₂⁻, CH₃SO₃⁻, CF₃SO₃⁻, CF₃COO⁻, BPh₄⁻, C(SO₂CF₃)₃⁻, NCS⁻, CN⁻, NCO⁻, and
n is an integer from 0, 1 to 5.

Further aspects and preferred embodiments of the invention are detailed herein below and in the appended claims. Further features and advantages of the invention will become apparent to the skilled person from the description of the preferred embodiments given below.

### Brief Description of the Drawings

Figure 1A shows chemical structure of compounds of formula (I): adamantane (AD) and 1-aminoadamantane (ADA) used as crystal defect mitigating agent or passivating agent for metal organohalide perovskite film. Figures 1B, C and D show SEM images of perovskite films modified by chlorobenzene CB (anti-solvent basis) (Figure 1B), by AD (Figure 1C), and by ADA (Figure ID) by using spin-coating technique.
**Figures 2A-C** show SEM images of perovskite films modified with chlorobenzene CB (anti-solvent basis) **(****Figure 2A****),** by AD **(****Figure 2B****),** and by ADA **(****Figure 2C****)** by using anti-solvent technique.
**Figure 3A** concerns XRD patterns of perovskite films passivated with ADA or AD by using anti-solvent technique (3^{rd} and 4^{th} curves from the top) and spin-coating (passivation) technique (1^{st} and 2^{nd} curves from the top). **Figure 3B** concerns UV-visible and Photoluminescence spectra of the same. **Figure 3C** concerns photoluminescence lifetime measurement (TRPL) spectra of perovskite films before and after passivation by Reference (left spectrum), AD (middle spectrum) and ADA (right spectrum), by using spin coating method.
**Figure 4A** concerns a cross-sectional SEM image of perovskite solar cell based on mesoporous TiO₂ scaffold and ADA passivation. **Figure4B** shows *J-V* curves of photovoltaic devices of the invention before and after passivation with AD and ADA using spin-coating technique with both backward and forward scan direction. **Figure4C** shows external quantum efficiency (EQE) spectra and integrated current density curves of the corresponding devices. **Figure4D** shows stabilized power output of the corresponding devices.
**Figures 5A-D** concern histograms of photovoltaic parameters of photovoltaic devices of the invention before and after passivation with AD and ADA molecules using spin-coating methods.
**Figure 6** concerns histogram of hysteresis index of photovoltaic devices of the invention before and after passivation with AD and ADA molecules using spin-coating methods.
**Figures 7A-D** concern histograms of photovoltaic parameters of photovoltaic devices of the invention before and after passivation with AD and ADA molecules using the anti-solvent method.
**Figures 8A-D** concern histograms of photovoltaic parameters of photovoltaic devices of the invention before and after passivation with the AD molecule at different concentrations (mg/mL) (X-axis) of AD using anti-solvent technique.
**Figures 9A-D** concern histograms of photovoltaic parameters of photovoltaic devices of the invention before and after passivation with ADA molecule with different concentration (mg/mL) (X-axis) of ADA using spin-coating method.

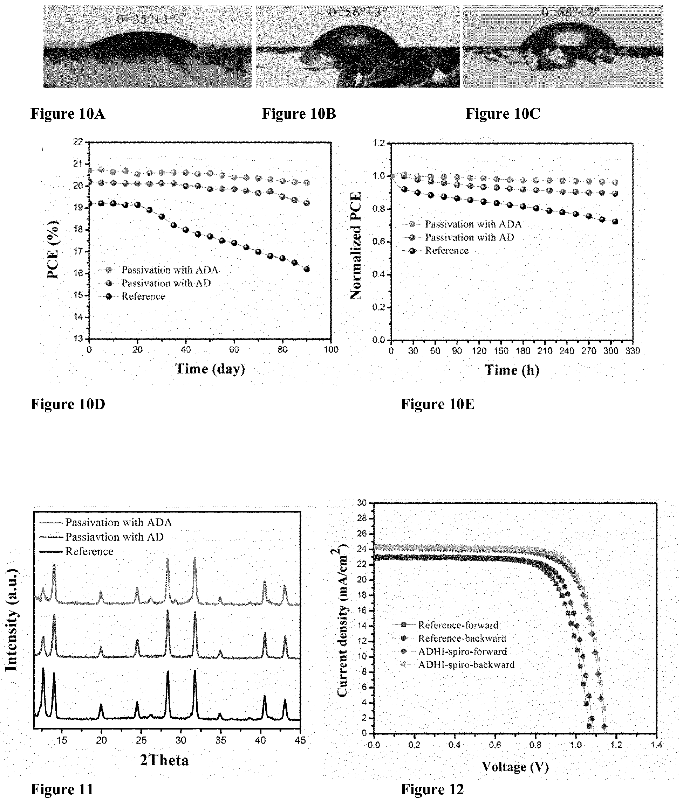

**Figures 10A-C** show contact angle measurements of water droplet on top of perovskite films: **(****Figure 10A****)** reference sample, **(****Figure 10B****)** AD-passivated film, **(****Figure 10C****)** ADA-passivated film. **Figure 10D** concerns stability test of corresponding perovskite solar cells in an ambient environment with 20% relative humidity (top curve: passivation with ADA, middle curve: passivation with AD, bottom curve: reference). **Figure 10E** concerns stability test of perovskite solar cells with and without passivation under continuous full-sun illumination and maximum power point tracking in a nitrogen atmosphere at T=30 °C (top curve: passivation with ADA, middle curve: passivation with AD, bottom curve: reference).
**Figure 11** concerns humidity test for perovskite films, being passivated or not, after keeping them at 65% humidity for one week and shows XRD patterns of the corresponding perovskite films (passivation with ADA: top curve, with AD: middle curve, no passivation/reference: bottom curve).
**Figure 12** shows *J- V* curves of devices based on reference (1^{st} and 2^{nd} curves from left) and Aminoadamantane hydroiodide (ADHI)-modified spiro-OMeTAD (3^{rd} and 4^{th} curves from left) with forward and backward scan directions.
**Figures 13A-D** show histograms of photovoltaic parameters of perovskite solar cells before and after in-situ passivation of perovskite solar cells with ADHI.
**Figure 14** concerns stability test of perovskite solar cells before and after passivation with ADHI.

### Detailed Description of the Preferred Embodiments

The present invention concerns an optoelectronic and/or photovoltaic device comprising a compound used as crystal defect mitigating agent or passivating agent, said compound being selected from a compound of formula (I) 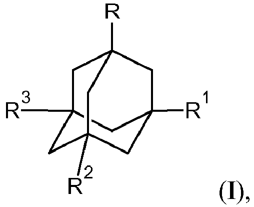 a compound of formula (II) 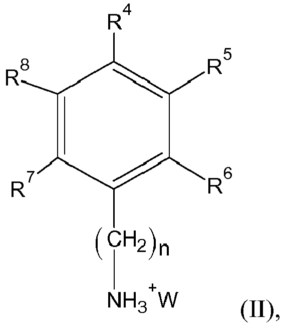 a mixture thereof, or
a compound of formula (III) being a compound of formula (I), of which substituent R is substituted by one compound of formula (II) being linked to said compound of formula (I) through any one of unsubstituted R⁴, R⁵, R⁶, R⁷ or R⁸, and wherein the substituent R⁴, R⁵, R⁶, R⁷ or R⁸ not being linked are independently selected from any substituent as defined below,
wherein
R, R¹, R², R³, R⁴, R⁵, R⁶, R⁷ and R⁸ are independently selected from H, -NH₂, -NCS, - CN, - NCO, -NH₃⁺, -NH₃⁺Y, -R⁹, -NHR⁹, -NR⁹R¹⁰, -O-R⁹, -S-R⁹, or halogen being selected from F, Cl, Br or I, wherein R⁹ and R¹⁰ are independently selected from C6-C15 aryl, C6-C15 heteroaryl, C3-C15 cycloalkyl group, C3-C15 heterocycloalkyl groups, C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein aryl, heteroaryl, cycloalkyl, heterocycloalkyl, alkyl, heteroalkyl, alkenyl, alkynyl group are unsubstituted or further substituted by halogen being selected from F, Cl, Br or I,
Y and W are independently selected from F⁻, Cl⁻, Br⁻, I⁻, SCN⁻, BF₄⁻, PF₆⁻, ClO₄⁻, N(SO₂CF₃)₂⁻, N(SO₂CF₂CF₃)₂⁻, CH₃SO₃⁻, CF₃SO₃⁻, CF₃COO⁻, BPh₄⁻, C(SO₂CF₃)₃⁻, NCS⁻, CN⁻, NCO⁻, and
n is an integer from 0, 1 to 5.

According to one embodiment, R¹, R², and R³ of the compound of formula (I) or of the compound of formula (III) are H.

According to another embodiment, substituent R of the compound of formula (I) is selected from H, -NH₂, -NH₃⁺, -NH₃⁺Y, -R⁹, -NHR⁹, -NR⁹R¹⁰, -O-R⁹, -S-R⁹, or halogen being selected from F, Cl, Br or I, wherein R⁹ and R¹⁰ are independently selected from C6-C15 aryl, C6-C15 heteroaryl, C3-C15 cycloalkyl group, C3-C15 heterocycloalkyl groups, Cl-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein aryl, heteroaryl, cycloalkyl, heterocycloalkyl, alkyl, heteroalkyl, alkenyl, alkynyl group are unsubstituted or further substituted by halogen being selected from F, Cl, Br or I, and wherein Y is selected from F⁻, Cl⁻, Br⁻, I⁻, SCN⁻, BF₄⁻, PF₆⁻, ClO₄⁻, N(SO₂CF₃)₂⁻, N(SO₂CF₂CF₃)₂⁻, CH₃SO₃⁻, CF₃SO₃⁻, CF₃COO⁻, BPh₄⁻, C(SO₂CF₃)₃⁻.

According to a further embodiment, R of the compound of formula (I) is selected from H, - NH₂, -NH₃⁺, -NH₃⁺Y, wherein Y is selected from F⁻, Cl⁻, Br⁻, I⁻, SCN⁻, BF₄⁻, PF₆⁻, ClO₄⁻, N(SO₂CF₃)₂⁻, N(SO₂CF₂CF₃)₂⁻, CH₃SO₃⁻, CF₃SO₃⁻, CF₃COO⁻, BPh₄⁻, C(SO₂CF₃)₃⁻.

According to one embodiment, the compound used as crystal defect mitigating agent or passivating agent is selected from a compound of formula (I) or a compound of formula (III). The compound used as crystal defect mitigating agent or passivating agent may be a compound of formula (I). The compound of formula (I) preferably is selected from adamantane, 1-aminoadamantane, a salt of adamantane being selected from ADHZ, wherein AD is selected from adamantane or 1-aminoadamantane and HZ, wherein HZ is selected from HI, HBr or HCl.

According to a further embodiment, the compound used as crystal defect mitigating agent or passivating agent is selected from a compound of formula (II).

R⁵, R⁶, R⁷ and R⁸ of the compound of formula (II) or, if present, of the compound of formula (III) are H and n is an integer from 1 to 5. n of compound of formula (I)) being an integer may be 0, 1, 2, 3, 4 or 5.

According to another embodiment, R⁴ of the compound of formula (II) or, if present, of the compound of formula (III), is selected from H, R⁹, -NHR⁹, -NR⁹R¹⁰, -O-R⁹, -S-R⁹, or halogen, wherein R⁹ and R¹⁰ are independently selected from C3-C15 cycloalkyl group, C3-C15 heterocycloalkyl groups, C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein cycloalkyl, heterocycloalkyl, alkyl, heteroalkyl, alkenyl, alkynyl group are unsubstituted or further substituted by halogen being selected from F, Cl, Br or I; and n is an integer from 1 to 5. R⁴ of the compound of formula (II) or, if present, of the compound of formula (III), may be selected from H or -R⁹, wherein R⁹ is independently selected from C3-C15 cycloalkyl group, C3-C15 heterocycloalkyl groups, C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein cycloalkyl, heterocycloalkyl, alkyl, heteroalkyl, alkenyl, alkynyl group are unsubstituted or further substituted by halogen being selected from F, Cl, Br or I; or from H or -R⁹, wherein R⁹ is independently selected from C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, or branched and wherein alkyl, heteroalkyl, alkenyl, alkynyl group are unsubstituted or further substituted by halogen being selected from F, Cl, Br or I.

One preferred compound of formula (II) among other of the same is 4-tert-butylbenzylamino hydroiodide.

According to one embodiment, the optoelectronic and/or photovoltaic device of the invention comprises a light-harvesting layer comprising a metal organohalide perovskite and a hole transport layer comprising a hole transport material, wherein the compound used as crystal defect mitigating agent or passivating agent is infiltrated in the light-harvesting layer and/or coats the top of the light-harvesting layer forming a layer being a passivation layer and/or is included into the hole transport layer, and wherein the hole transport layer is in electric contact with the light-harvesting layer and/or the passivation layer. In particular, the optoelectronic and/or photovoltaic device may comprise a light-harvesting layer infiltrated by the crystal defect mitigating agent or passivating agent, which may partially or totally covered the light harvesting layer, or a light-harvesting layer coated by a passivation layer comprising said crystal defect mitigating agent or passivating agent, or a hole transport layer comprising a hole transport material and said crystal defect mitigating agent or passivating agent, similarly as to an additive.

For the purpose of the present specification, the expression "in electric contact with" or "in contact with" means that electrons or holes can get from one layer to the other layer with which it is in electric contact, at least in one direction. In particular, considering the electron flow in the operating device exposed to electromagnetic radiation, layers through which electrons and/or holes are flowing are considered to be in electric contact. The expression "in electric contact with" does not necessarily mean, and preferably does not mean, that electrons and/or holes can freely move in any direction between the layers. The expression "in electric contact with" or "in contact with" does not necessarily mean to be directly in electric contact with or in direct contact with, but "in electric contact with" may also mean to be in contact through intermediate and/or optional layer, or optional and/or intermediate layer may be present there between.

To passivate the light-harvesting layer in the optoelectronic and/or photovoltaic device of the said layer, the compound used as crystal defect mitigating agent or passivating agent, i.e. a compound selected from a compound of formula (I), (II), a mixture of compounds of formula (I) and (II), or a compound of formula (III), may be applied (a) with the anti-solvent solution onto the metal organohalide perovskite pigment already applied onto the n-type semiconductor and/or the electron transport layer, said passivating agent infiltrating the perovskite pigment, and/or (b) after the annealing of the metal organohalide perovskite film to form a passivation layer and/or (c) with the application of the hole transport layer as an additive to the hole transport material. Such a method of producing an optoelectronic and/or photovoltaic device with a passivated metal organohalide perovskite film is advantageous, since the step of passivating may be included in the existing steps of fabrication or application of the light-harvesting layer with metal organohalide perovskite and/or the hole transport layer.

The techniques used to apply the passivating agent are not limited to the specific techniques described further. In particular, the technique used in the application of the passivating agent with the anti-solvent, which may be chlorobenzene, is called anti-solvent technique and the light-harvesting layer infiltrated with the passivating agent is further annealed before the application of one or more further layers selected from hole transport layer and back contact. As for the application of the passivating agent after the application of the metal organohalide perovskite pigment and the optional anti-solvent solution and the annealing of the light-harvesting layer, the used technique is selected from spin-coating or doctor blading. The passivation layer is then annealed. In the case the application with the hole transport layer, the passivating agent, preferably under the form of a salt, is mixed with the hole transport material before its application by a technique selected from spin-coating or doctor blading.

According to another embodiment, the optoelectronic and/or photovoltaic device further comprises a conducting support layer, n-type semiconductor, an electron transport layer and a back contact, wherein the n-type semiconductor is in electric contact with the conducting support layer and the electron transport layer is in electric contact with the n-type semiconductor; and the back contact is in electric contact with the hole transport layer. The hole transport layer is in electric contact with the light-harvesting layer infiltrated by a passivating agent of the invention or a compound used as a crystal defect mitigating agent and/or coated by the same.

In particular, the optoelectronic and/or photovoltaic device of the invention comprises an electron transport layer, a light-harvesting layer and a hole transport layer, wherein the light-harvesting layer comprises a metal organohalide perovskite and is provided on the electron transport layer and the light-harvesting layer may further comprise a crystal defect mitigating or passivating agent as defined herein or the hole transport layer (HTL) may comprise said crystal defect mitigating or passivating agent.

The electron transport layer (ETL) may form a planar structure and the metal organohalide perovskite may infiltrate the same. In an optoelectronic and/or photovoltaic device based on an ETL/light harvesting structure/HTL, the metal organohalide perovskite and the crystal defect mitigating agent or passivating agent of the invention, in particular if applied with the anti-solvent solution or method may infiltrate the whole structure. ETL may comprise mesoporous oxide layer. In particular, the ETL may be a multilayer structure comprising at least one amorphous metal oxide layer and at least one mesoporous metal oxide layer, the at least one amorphous metal oxide layer being in electric contact with the light harvesting layer and said at least one mesoporous metal oxide is in electric contact with at least one amorphous metal oxide layer. The ETL comprises at least one layer comprising an amorphous metal oxide and at least one layer comprising a crystalline mesoporous metal oxide. In the ETL, at least one amorphous metal oxide layer is in electric contact with the light harvesting layer and at least one mesoporous metal oxide layer is in electric contact with at least one amorphous metal oxide layer. The ETL may be a multilayer structure or scaffold comprising at least two layers of metal oxide, the first layer being a mesoporous metal oxide layer and the second layer being an amorphous metal oxide layer. The ETL may comprise one or more mesoporous metal oxide layers, said mesoporous metal oxides being identical or different metal oxides. The ETL may comprise one or more amorphous metal oxide layers. When the ETL comprises more than one amorphous metal oxides layers, one amorphous metal oxide layer is in electric contact with the mesoporous metal oxide layer and one amorphous metal oxide layer is in electric contact with the light harvesting layer.

In an embodiment, the electron transport layer comprises an amorphous metal oxide layer. In a further embodiment, at least one layer of the ETL comprising an amorphous metal oxide is provided on the layer comprising a crystalline mesoporous metal oxide.

The metal oxides of the ETL are selected from n-type semiconductor particles being TiO₂ or ZnO particles. The crystalline mesoporous metal oxide is selected from mesoporous TiO₂ or mesoporous ZnO. The thickness of the ETL is in the range from 50 nm to 1000 nm, preferably from 50 to 600 nm. The thickness of the amorphous metal oxide layer is in the range from 10 nm to 30 nm.

The conducting support layer is preferably substantially transparent. "Transparent" means transparent to at least a part, preferably a major part of the visible light. Preferably, the conducting support layer is substantially transparent to all wavelengths or types of visible light. Furthermore, the conducting support layer may be transparent to non-visible light, such as UV and IR radiation, for example. The conducting support layer provides the support layer the optoelectronic and/or photovoltaic device. Preferably, the optoelectronic and/or electrochemical device is built on said support layer. The support of the device may be also provided on the side of the back contact or counter electrode. In this case, the conductive support layer does not necessarily provide the support of the device, but may simply be or comprise a current collector, for example a metal foil.

The conducting support layer functions and/or comprises a current collector, collecting the current obtained from the device. The conducting support layer may comprise a material selected from indium doped tin oxide (ITO), fluorine doped tin oxide (FTO), ZnO-Ga₂O₃, ZnO-Al₂O₃, tin-oxide, antimony doped tin oxide (ATO), SrGeO₃ and zinc oxide, preferably coated on a transparent substrate, such as plastic or glass. In this case, the plastic or glass provides the support structure of the layer and the cited conducting material provides the conductivity. Such support layers are generally known as conductive glass and conductive plastic, respectively, which are thus preferred conducting support layers in accordance with the invention. The conducting support layer comprises a conducting transparent layer, which may be selected from conducting glass and from conducting plastic.

In particular, the n-type semiconductor comprises a metal oxide layer. Preferably the n-type semiconductor comprises a compact metal oxide layer. The n-type semiconductor further comprises a mesoporous/ nanoporous/nanostructured metal oxide being a surface-increasing scaffold structure provided onto the compact metal oxide layer. The n-type semiconductor comprises metal oxide particles selected from Si, TiO₂, SnO₂, ZnO, Zn₂SnO₄, Nb₂O₅, WO₃, BaTiO₃ or SrTiO₃ or any combination thereof. The metal oxide particles of the mesoporous layer and the metal oxide particles of the scaffold structure may be made of the same or different metal oxide described above.

By "hole transport material", "hole transporting material", "organic hole transport material" and "inorganic hole transport material", and the like, is meant any material or composition wherein charges are transported by electron or hole movement (electronic motion) across said material or composition. The "hole transport material" is thus an electrically conductive material. Such hole transport materials, etc., are different from electrolytes. In this latter, charges are transported by diffusion of molecules.

Hole transport material may be selected from organic and/or inorganic hole transport materials or p-type semiconductor.

In one embodiment, the hole transport material is selected from semiconductor particles comprising NiO, CuO, CuSCN, CuI, CuGaO₂, CuCrO₂ or CuAlO₂ or any combination thereof or from triphenylamine, carbazole, N,N,(diphenyl)-N',N'di-(alkylphenyl)-4,4'-biphenyldiamine, (pTPDs), diphenylhydrazone, poly [N,N'-bis(4-butylphenyl)-N,N'-bis(phenyl)benzidine] (polyTPD), polyTPD substituted by electron donor groups and/or acceptor groups, poly(9,9-dioctylfluorene-alt-N-(4-butylphenyl)-diphenylamine (TFB), 2,2',7,7'-tetrakis-N,N-di-p-methoxyphenylamine-9,9'-spirobifluorene) (spiro-OMeTAD), N,N,N',N'-tetraphenylbenzidine (TPD), PTAA (Poly[bis(4-phenyl)(2,4,6-trimethylphenyl)amine]).

The thickness of the p-type semiconductor layer is in the range from 40 nm to 1000 nm, from 40 to 200nm, from 40 to 70 nm, from 40 to 60 nm. Preferably the hole transporting layer comprises a film free of pinholes and having a thickness from 40 to 70 nm, being uniform, i.e. comprising one type of conformal structure (only one type of layer stacking order) of the hole transporting material. Such a type of film is provided by dynamic deposition method of the hole transporting material in solution on the underlying layer, the light-harvesting layer, or the passivation layer or any further layer being optional between the light-harvesting layer and the hole transport layer. Such a dynamic method may comprise a drop-casting step with spinning of the hole transporting material in solution, namely dissolved in a solvent selected from diethyl sulfide, propyl sulphide, or a mixture of diethyl and propyl sulphide and drop-casted in a short time period (2-3 seconds) with a spinning at 5000 rpm. The crystal defect mitigating agent or passivating agent as described herein may be applied with the hole transport material, said crystal defect mitigating agent or passivating agent as such or under the form of salt being added to the hole transport material solution before its application.

The back contact generally comprises a catalytically active material, suitable to provide electrons and/or fill holes towards the inside of the device. The back contact may comprise one or more materials selected from Pt, Au, Ni, Cu, Ag, In, Ru, Pd, Rh, Ir, Os, porous carbon (C), conductive polymer and a combination of two or more of the aforementioned. Conductive polymers may be selected from polymers comprising polyaniline, polypyrrole, polythiophene, polybenzene, polyethylenedioxythiophene, polypropylenedioxy-thiophene, polyacetylene, and combinations of two or more of the aforementioned, for example. Preferably the back contact is selected from gold (Au), silver (Ag), aluminium (Al), copper (Cu), platinum (Pt), nickel (Ni). Furthermore, the back contact is more preferably gold (Au) with a thickness of range between 50 nm and 200 nm. Additionally, said electrode may be porous Carbon (C).

The perovskite structure has the general stoichiometry AMX₃, where "A" and "M" are cations and "X" is an anion. The "A" and "M" cations can have a variety of charges and in the original Perovskite mineral (CaTiO₃), the A cation is divalent and the M cation is tetravalent. For the purpose of this invention, the perovskite formulae include structures having three or four anions, which may be the same or different, and/or one or two organic cations, and/or metal atoms carrying two or three positive charges, in accordance with the formulae presented herein.

The light-harvesting layer, sensitizer layer or light-absorber layer, said terms being equivalently used and defining the same structure, may comprise one or more layers of an organic-inorganic perovskite or metal organohalide perovskite or organohalide perovskite. In said device, the last upper layer of organic-inorganic perovskite or metal organohalide perovskite may be coated by the hole transport material or, if present by a layer underlying the hole transport layer. The organic-inorganic perovskite or metal organohalide perovskite may be provided on the mesoscopic part of the n-type semiconductor or on the metal oxide layer of the ETL.

According to another embodiment, the metal organohalide perovskite is selected from a perovskite structure according to any one of formulae (I), (Ia), (Ib), (Ic), (Id), (Ie), (If) and/or (Ig) below:

| | |
|---|---|
| AA'MX₄ | (I) |
| AMX₃ | (Ia) |
| AA'N_{2/3}X₄ | (Ib) |
| AN_{2/3}X₃ | (Ic) |
| BN_{2/3}X₄ | (Id) |
| BMX₄ | (Ie) |
| (Aₗ)ₘAA'MX₃ | (If) |
| (Aₗ)ₘAMX₃ | (Ig) |

wherein,
- A and A' are organic, monovalent cations being independently selected from primary, secondary, tertiary or quaternary organic ammonium compounds, including N-containing heterorings and ring systems, A and A' having independently from 1 to 60 carbons and 1 to 20 heteroatoms;
- A₁ is an inorganic cation selected from Cs⁺, Rb⁺, K⁺ and m is an integer from 1 to 3, each A₁ if m >1 being different;
- B is an organic, bivalent cation selected from primary, secondary, tertiary or quaternary organic ammonium compounds having from 1 to 60 carbons and 2-20 heteroatoms and having two positively charged nitrogen atoms;
- M is selected from Cu²⁺, Ni²⁺, Co²⁺, Fe²⁺, Mn²⁺, Cr²⁺, Pd²⁺, Cd²⁺, Ge²⁺, Sn²⁺, Pb²⁺, Eu²⁺, Yb²⁺, [SnᵢPb₍₁₋ᵢ₎]⁺, [SnⱼGe₍₁₋ⱼ₎]⁺, and [PbₖGe₍₁₋ₖ₎]⁺, i, j and k being a number between 0.0 and 1.0;
- N is selected from the group of Bi³⁺ and Sb³⁺; and,
- X are independently selected from Cl⁻, Br⁻, I⁻, NCS⁻, CN⁻, NCO⁻, from [I₍₃₋ₒ₎Clₒ]⁻, [I₍₃₋ₚ₎Brₚ]⁻, [Br₍₃₋ᵤ₎Clᵤ]⁻, o, p and u being a number between 0.0 and 3.0, and from a combination of two anions selected from Cl⁻, Br⁻, I⁻.

In particular, the three or four X may be identical or different. For example, in AMX₃ (formula Ia) may be expressed as formula (Ia'): AMXiXiiXiii (Ia'), wherein Xi, Xii, Xiii are independently selected from Cl⁻, Br⁻, I⁻, NCS⁻, CN⁻, NCO⁻, from [I₍₃₋ₒ₎Clₒ]⁻, [I₍₃₋ₚ₎Brₚ]⁻, [Br₍₃₋ᵤ₎Clᵤ]⁻, o, p, and u being a number between 0.0 and 3.0, and from a combination of two anion selected from Cl⁻, Br⁻, I⁻, preferably from halide (Cl⁻, Br⁻, I⁻) and A and M are as defined elsewhere in this specification. Xi, Xii, Xiii may thus be the same or different in this case.

Preferably, if Xi, Xii, Xiii in formulae (Ia) and (Ic) or Xi, Xii, Xiii, Xiv in formulae (I), (Ib), (Id) or (Ie) comprise different anions X, there are not more than two different anions. For example, Xi and Xii being the same with Xiii being an anion that is different from Xi and Xii.

According to perovskite-structure of formula (If) or (Ig), A and A' are independently selected from methylammonium cation, formamidinium cations, iodo-carbamimidoyl cation or a combination of said cations.

According to a preferred embodiment, said perovskite or metal organohalide perovskite layer comprises a perovskite-structure according to any one of the formulae (Ih) to (In):

| | |
|---|---|
| APbX₃ | (Ih) |
| ASnX₃ | (Ii) |
| ABiX₄ | (Ij) |
| AA'PbX₄ | (Ik) |
| AA'SnX₄ | (Il) |
| BPbX₄ | (Im) |
| BSnX₄ | (In) |

wherein A, A', B and X are as defined above in this specification. Preferably, X is preferably selected from Cl⁻, Br⁻ and I⁻, most preferably X is I⁻ or a mixture of Br⁻ and I⁻.

The light-harvesting layer comprising organic-inorganic perovskite or metal organohalide perovskite may comprise a perovskite-structure according to any of the formulae (If) to (Im), more preferably (If), (Ih) and/or (Ii).

According to an embodiment, A and A' are monovalent cations selected independently from any one of the compounds of formulae (20) to (28) below: 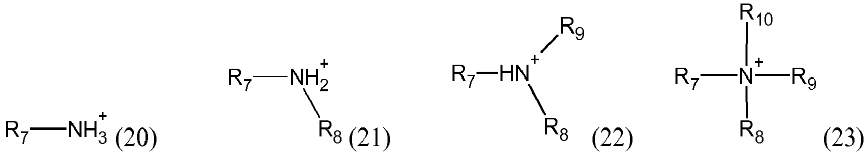 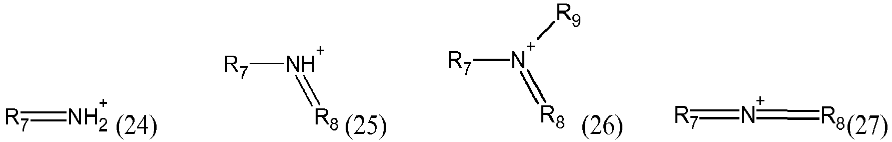 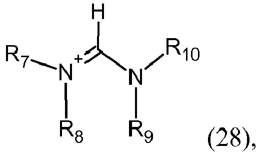 wherein R₇, R₈, R₉ and R₁₀ is independently selected from C1-C15 organic substituents comprising from 0 to 15 heteroatoms.

According to an embodiment of said C1-C15 organic substituent any one, several or all hydrogens in said substituent may be replaced by halogen and said organic substituent may comprise up to fifteen (15) N, S or O heteroatoms, and wherein, in any one of the compounds (20) to (28), the two or more of substituents present (R₇, R₈, R₉ and R₁₀, as applicable) may be covalently connected to each other to form a substituted or unsubstituted ring or ring system. Preferably, in a chain of atoms of said C1-C15 organic substituent, any heteroatom is connected to at least one carbon atom. Preferably, neighboring heteroatoms are absent and/or heteroatom-heteroatom bonds are absent in said C1-C15 organic substituent comprising from 0 to 15 heteroatoms. The heteroatoms may be selected from N, S, and/or O.

According to an embodiment, R₇, R₈, R₉ and R₁₀ are independently selected from C1 to C15 aliphatic and C4 to C15 aromatic or hetero aromatic substituents, wherein any one, several or all hydrogens in said substituent may be replaced by halogen and wherein, in any one of the compounds (20) to (28), the two or more of the substituents present may be covalently connected to each other to form a substituted or unsubstituted ring or ring system.

According to a preferred embodiment, the organic-inorganic perovskite is selected from a compound of formula (I), (Ia), (If) or (Ig).

According to an embodiment, B is a bivalent cation selected from any one of the compounds of formulae (29) and (30) below:

R₁₁-G-R₁₂ (29)

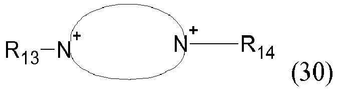

wherein,
in the compound of formula (29), G is an organic linker structure having 1 to 10 carbons and 0 to 5 heteroatoms selected from N, S, and/or O, wherein one or more hydrogen atoms in said G may be replaced by halogen;
wherein R₁₁ and R₁₂ are independently selected from a compounds of any one of formulae (20) to (28); and wherein, in the compound of formula (30), the circle containing said two positively charged nitrogen atoms represents a substituted or unsubstituted aromatic ring or ring system comprising 4 to 15 carbon atoms and 2 to 7 heteroatoms or 4 to 10 carbon atoms and 2 to 5 heteroatoms, wherein said nitrogen atoms are ring heteroatoms of said ring or ring system, and wherein the remaining of said heteroatoms may be selected independently from N, O and S and wherein R₁₃ and R₁₄ are independently selected from H and from a compounds of any one of formulae (20) to (28). Halogen atom substituting hydrogen atom totally or partially may also be present in addition to and/or independently of said 2 to 7 heteroatoms.

Preferably, if the number of carbons is in G is impair, the number of heteroatoms is smaller than the number of carbons. Preferably, in the ring structure of formula (30), the number of ring heteroatoms is smaller than the number of carbon atoms. According to an embodiment, G is an aliphatic, aromatic or hetero aromatic linker structure having from 1 to 10 carbons.

According to an embodiment, R₇, R₈, R₉ and R₁₀ are independently selected from C1 to C10 alkyl, C2 to C10 alkenyl, C2 to C10 alkynyl, C4 to C10 heteroaryl and C6 to C10 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R₇, R₈, R₉ and R₁₀ may be replaced by halogen.

According to an embodiment, R₇, R₈, R₉ and R₁₀ are independently selected from C1 to C8 alkyl, C2 to C8 alkenyl, C2 to C8 alkynyl, C4 to C8 heteroaryl and C6 to C8 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R₇, R₈, R₉ and R₁₀ may be replaced by halogen.

According to an embodiment, R₇, R₈, R₉ and R₁₀ are independently selected from C1 to C6 alkyl, C2 to C6 alkenyl, C2 to C6 alkynyl, C4 to C6 heteroaryl and C6 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R₇, R₈, R₉ and R₁₀ may be replaced by halogen.

According to an embodiment, R₇, R₈, R₉ and R₁₀ are independently selected from C1 to C4 alkyl, C2 to C4 alkenyl and C2 to C4 alkynyl, wherein said alkyl, alkenyl and alkynyl, if they comprise 3 or more carbons, may be linear, branched or cyclic, and wherein several or all hydrogens in R₇, R₈, R₉ and R₁₀ may be replaced by halogen.

According to an embodiment, R₇, R₈, R₉ and R₁₀ are independently selected from C1 to C3, preferably C1 to C2 alkyl, C2 to C3, preferably C2 alkenyl and C2 to C3, preferably C2 alkynyl, wherein said alkyl, alkenyl and alkynyl, if they comprise 3 or more carbons, may be linear, branched or cyclic, and wherein several or all hydrogens in R₇, R₈, R₉ and R₁₀ may be replaced by halogen.

According to an embodiment, R₇, R₈, R₉ and R₁₀ is independently selected from C1 to C4, more preferably C1 to C3 and even more preferably C1 to C2 alkyl. Most preferably R₇, R₈, R₉ and R₁₀ are methyl. Again, said alkyl may be completely or partially halogenated.

According to an embodiment, A, A' and B are monovalent (A, A') and bivalent (B) cations, respectively, selected from substituted and unsubstituted C5 to C6 rings comprising one, two or more nitrogen heteroatoms, wherein one (for A and A') or two (for B) of said nitrogen atoms is/are positively charged. Substituents of such rings may be selected from halogen and from C1 to C4 alkyls, C2 to C4 alkenyls and C2 to C4 alkynyls as defined above, preferably from C1 to C3 alkyls, C3 alkenyls and C3 alkynyls as defined above. Said ring may comprise further heteroatoms, which may be selected from O, N and S. Bivalent organic cations B comprising two positively charged ring N-atoms are exemplified, for example, by the compound of formula (30) above. Such rings may be aromatic or aliphatic.

A, A' and B may also comprise a ring system comprising two or more rings, at least one of which being from substituted and unsubstituted C5 to C6 ring as defined as above. The elliptically drawn circle in the compound of formulae (30) may also represent a ring system comprising, for example, two or more rings, but preferably two rings. Also, if A and/or A' comprises two rings, further ring heteroatoms may be present, which are preferably not charged, for example.

According to an embodiment, however, the organic cations A, A' and B comprise one (for A, A'), two (for B) or more nitrogen atom(s) but are free of any O or S or any other heteroatom, with the exception of halogens, which may substitute one or more hydrogen atoms in cation A and/or B.

A and A' preferably comprise one positively charged nitrogen atom. B preferably comprises two positively charged nitrogen atoms.

A, A' and B may be selected from the exemplary rings or ring systems of formulae (31) and (32) (for A, A') and from (33) to (35) (for B) below: 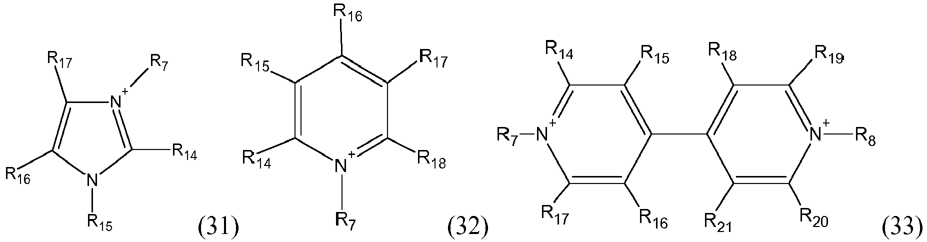 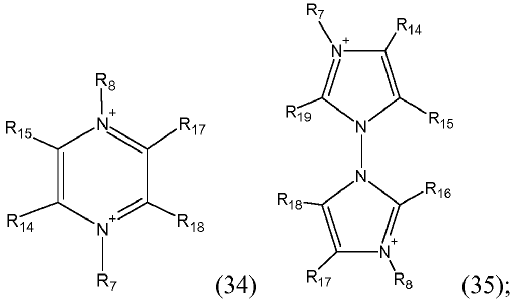 wherein
R₇ and R₈ are selected from substituents as defined above, and R₁₄, R₁₅, R₁₆, R₁₇, R₁₈, R₁₉, R₂₀ and R₂₁ are independently selected from H, halogen and substituents as defined above for R₇, R₈, R₉ and R₁₀. Preferably, R₁₄, R₁₅, R₁₆, R₁₇, R₁₈, R₁₉, R₂₀ and R₂₁ are selected from H and halogen, most preferably H.

In the organic cations A, A' and B, hydrogen atoms may be substituted by halogens, such as F, Cl, I, and Br, preferably F or Cl. Such a substitution is expected to reduce the hygroscopic properties of the perovskite layer or layers and may thus provide a useful option for the purpose of the present specification.

According to a preferred embodiment, A and A' are independently selected from organic cations of formula (20) and/or formula (28).

According to a preferred embodiment, the metal M is selected from Sn²⁺ and Pb²⁺, preferably Pb²⁺. According to a preferred embodiment, N is Sb³⁺.

According to a preferred embodiment, the three or four X are independently selected from Cl⁻, Br⁻, and I⁻.

The light harvesting compound used in these devices is not restricted to perovskite light absorbers but also comprising of a two dimensional (2D) or three dimensional (3D) or combination of both.

According to one embodiment, the optoelectronic and/or photovoltaic device of the invention is selected from an organic photovoltaic device, a photovoltaic solid state device, a p-n heterojunction, a metal organohalide perovskite photovoltaic device, a metal organohalide perovskite solar cell, a solid state solar cell, a phototransistor or LED (light-emitting diode).

According to a further embodiment, the optoelectronic and/or photovoltaic device of the invention is selected from an organic photovoltaic device, a photovoltaic solid state device, a p-n heterojunction, a metal organohalide perovskite photovoltaic device, a metal organohalide perovskite solar cell, or a solid state solar cell.

The optoelectronic and/or photovoltaic device may be operated in forward bias to serve as a light emitting diode (LED).

The present invention is described more concretely with reference to the following examples, which, however, are not intended to restrict the scope of the invention.

Although the present invention has been explained in relation to its preferred embodiment, it is to be understood that many other possible modifications and variations can be made without departing from the scope of the invention as hereinafter claimed.

### Examples

### Example 1:

### Crystal defect mitigating agents: adamantane (AD) or 1-aminoadamantane (ADA)

### Device fabrication

FTO glass (NSG-10) was first etched by a chemical method using zinc powder and HCl solution (2 M). To deposit the compact TiO₂ layer (c-TiO₂), titanium diisopropoxide acetyl acetonate (Sigma-Aldrich) was diluted in ethanol and deposited on substrates at 450 °C by using spray pyrolysis method, followed by 30 min annealing at 450°C. Thereafter, a 150 nm-thick mesoporous TiO₂ layer was spin coated on the c-TiO₂ (4000 rpm for 15 s with a ramp rate of 2000 rpm/s) using diluted TiO₂ paste (Dyesol 30 NR-D) in ethanol. Then, the substrates were annealed at 450°C for 30 min. After cooling the substrates to 150 °C, they were transferred to the glovebox for perovskite deposition.

The precursor solution was prepared by mixing FAI (1.105 M, Dyesol), PbI₂ (1.16 M, TCI), MABr (0.195 M, Dyesol) and PbBr₂ (0.195 M, TCI), and CsI (0.068 M, TCI) in DMF:DMSO = 4:1 (volume ratio). The perovskite solution was spin-coated in two-step first at 1000 rpm for 10 s and, then at 4000 rpm for 30 s. During the second step, 200 µL of chlorobenzene (CB) anti-solvent was dropped on top of film 5 s before the end of spinning. Then, the film was annealed at 100 °C for 80 min.

For passivation of perovskite film, the AD or ADA was either added to the anti-solvent chlorobenzene (anti-solvent (AS) method) or deposited by spin coating as separated layer (spin-coating (SC) method). Thus, in the AS method, perovskite films were passivated during applying anti-solvent on top of the film before annealing, while in the SC technique, after annealing the perovskite film, various solutions of AD and ADA additives with different concentrations were deposited on top of perovskite layer by spin-coating at 4000 rpm for 30 s with a ramp rate of 2000 rpm/s. Afterward, the passivated films were annealed at 120 °C for 10 min. After annealing, spiro-OMeTAD solution in chlorobenzene (70 mM) containing bis(trifluoromethylsulfonyl)imide lithium salt (Li-TFSI, Sigma-Aldrich) solution (520 mg/ml acetonitrile) and (4-tert-butylpyridine-Sigma-Aldrich) with molar ratios of 0.5 and 3.3, respectively, was prepared and spin-coated at 4000 rpm for 20 s with 2000 rpm/s ramp rate. Finally, the device structure was completed by thermal evaporation of 80-nm thick gold as an electrode with an active area of 0.16 cm².

### Crystal defect mitigating agents or passivating agent: salt of 1-aminoadamantane ADHZ

### Synthesis of ADHZ salt

1-aminoadamantane (ADA) and HI or HBr or HCl were mixed with 1:1 molar ratio and ethanol was added into the solution in order to remove water from the solution. Then, the solvent of solution was removed using rotary evaporator at 50 °C in order to get a solid powder as final product. Then the powder was purified using diethyl ether several times.

### In-situ passivation of perovskite film using ADHI

Spiro-OMeTAD has been used as a HTL and the spiro-OMeTAD solution was prepared with 70 mM. For doping purpose, first the spiro-OMeTAD (70 mM) and adamantane hydroiodide (ADHI) salts were mixed and dissolved in chlorobenzene with different concentration of ADHI. Then, tBP and bis(trifluoromethylsulfonyl)imide lithium salt (Li-TFSI, Sigma-Aldrich) (520 mg/1 mL acetonitrile) were added into the solution with molar ratios of 3.3 and 0.5, respectively. For ADHI adduct, extra tBP (2 M) was added into the solution to obtain a clear solution. Afterward, the spiro- OMeTAD solutions were spin-coated on top of perovskite film at 4000 rpm for 20 s with ramp rate of 2000 rpm.

### Film characterization

The morphology of perovskite film, and device structure was studied using a ZEISS Merlin high resolution scanning electron microscopy (HRSEM). Quality and crystal structure of perovskite films were characterized by using X-ray diffraction (Bruker D8 X-ray Diffractometer, USA) utilizing a Cu *Kα* radiation. For optical absorption measurement, a Varian Carry 500 spectrometer (Varian, USA) was used. To record steady-state photoluminescence spectra, an Edinburgh Instruments FLS920P fluorescence spectrometer, and for photoluminescence lifetime measurement (TRPL), a picosecond pulsed diode laser (EPL-405, excitation wavelength 405 nm, pulse width 49 ps) were employed. In order to analysis of TRPL results, PL decay curves were fitted to the following exponential function I(t)=I₀exp(-(t/τ)^{β}), where τ is the decay time and β is a stretch parameter.

### Device characterization

The solar cells were measured under AM1.5G sun simulator (a 450 W Xenon lamp (Oriel), with intensity of 100 mWcm⁻², equipped with a Schott K113 Tempax sunlight filter (Praezisions Glas & Optik GmbH) to simulate the emission spectra of AM1.5G standard in the region of 350-750 nm. Calibration of the lamp was performed using standard Silicon solar cell. To measure the current density-voltage (*J-V*) curves, a 2400 series source meter (Keithley, USA) instrument was employed. The voltage range for *J- V* sweeps was between 0 and 1.2 V, with a step size of 0.005 V and a delay time of 200 ms at each point. External quantum efficiency (EQE) spectra were measured with a commercial apparatus (Arkeo-Ariadne, Cicci Research s.r.l.) based on a 300 Watts Xenon lamp. Ecopia HMS 3000 setup (Microworld) with a magnetic field of 0.54 T in a 4-point configuration was used for Hall effect measurement. For this purpose, the perovskite film was deposited on glass slide using the same method and indium metal was used for electrode at four corners. In addition, the thickness of the perovskite films was controlled by a profiler (Tencor Alpha step 500). A biologic MPG2 potentiostat and a white LED lamp were used to simulate full AM 1.5 Sun-equivalent for stability test. The stability measurement was performed in nitrogen atmosphere under continuous light illumination using a device with active area of masked to 0.16 cm². The maximum power point (MPP) and *J-V* curve of devices were recorded every 10 s and every 10 min, respectively.

### Results

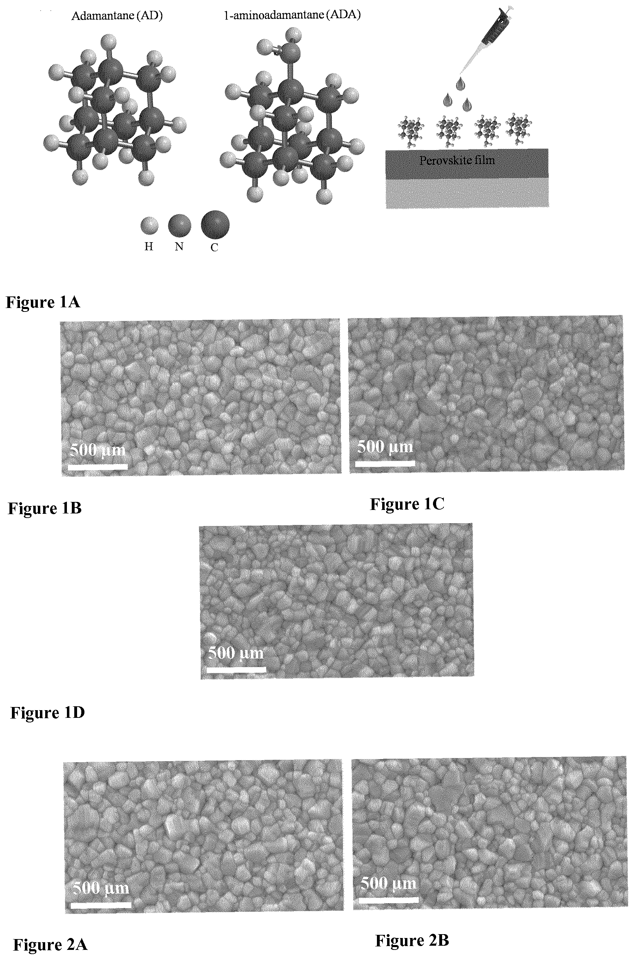

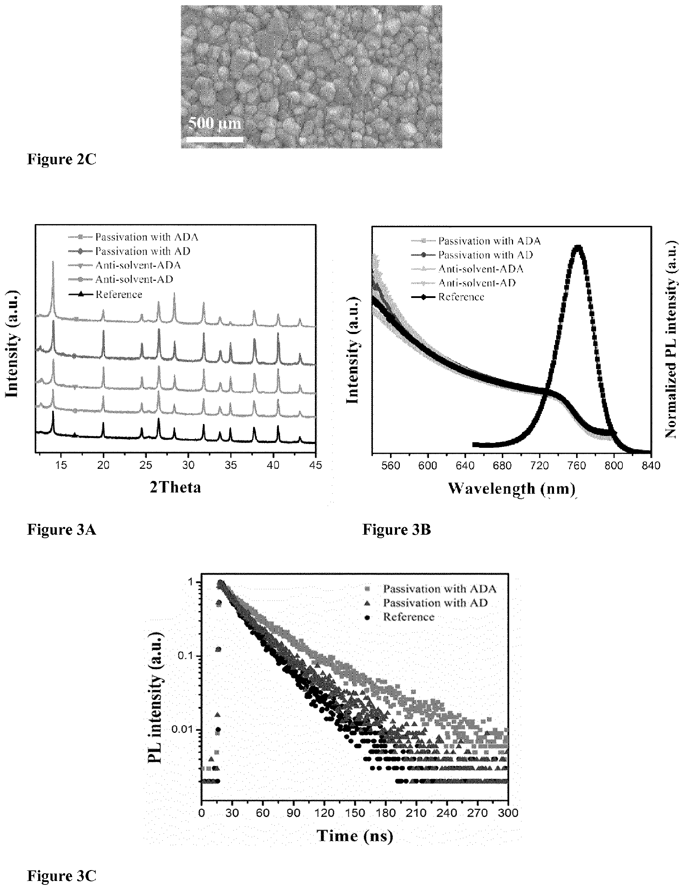

According to Figures 1A-D, Figures 2A-C and Figure 3A, the passivation of perovskite film with AD or ADA does not significantly affect the morphology of the perovskite film. There is no discernible shift in the UV and PL peaks after incorporation of the additives inside the perovskite film whose band gap is about = 1.61 eV (see Figure 3B). Figure 3C depicts time resolved photoluminescence (TRPL) traces of perovskite films deposited on glass substrate before and after surface passivation with AD or ADA molecules. The PL lifetimes follow the order ADA > AD > reference illustrating that ADA is most effective in mitigating perovskite surface states acting as charge carrier recombination centers (see Table 1).

**Table 1. Fitting parameters of the corresponding PL decay curves (τ: time decay, β: a stretch parameter, χ²: fitting range).**

| Sample | τ (ns) | β | χ² |
|---|---|---|---|
| Reference | 14.3 | 0.79 | 1.01 |
| Passivation with AD | 34.6 | 0.83 | 1.03 |
| Passivation with ADA | 68.4 | 0.81 | 1.07 |

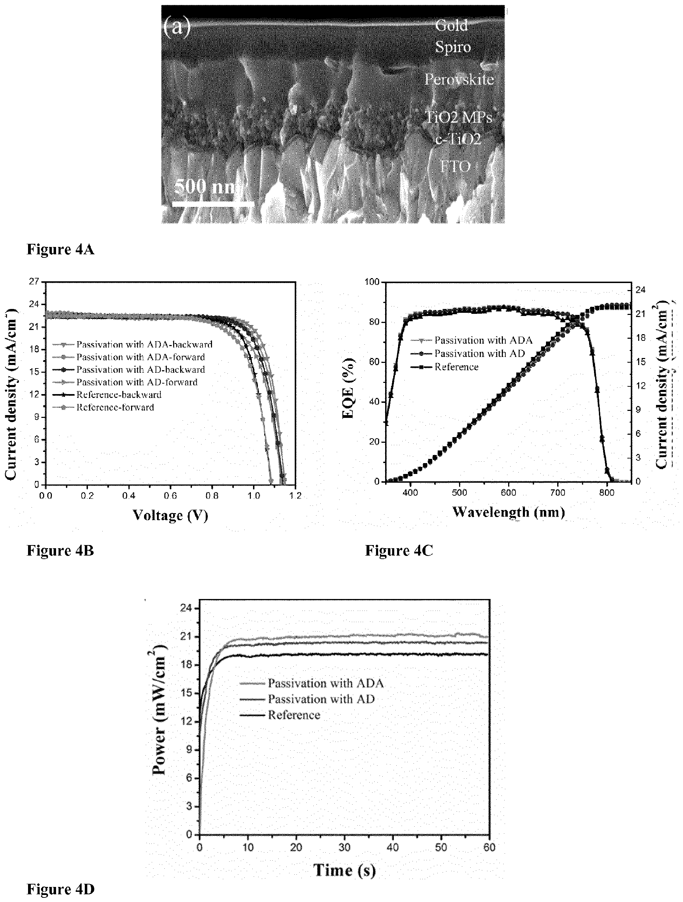

The device parameters of the solar cells with best performance are summarized in Table 2 (see also Figures 4A-B). The reference cell based on triple cation perovskite film gave a *J_{sc}* of 22.47 mA/cm², *V_{oc}* of 1.083 V, fill factor (FF) of 79.1%, and PCE of 19.32%. In contrast, AD-based device and ADA containing device exhibit significant improvement in *V_{oc}.* Thus, the PSC based on ADA treatment presents higher PCE up to 20.93% with *J_{sc}* of 22.57 mA/cm², *V_{oc}* of 1.155 V, and FF of 80.4%, while the AD-based solar cell shows the best performance of 20.47% (*J_{sc}* of 22.53 mA/cm², *V_{oc}* of 1.142 V, and FF of 79.3%). Notably, all PV parameters are improved by using AD and ADA molecules as additives. Nevertheless, from Figure 4b and Table 2, the *V_{oc}* emerges as the metric that profits the most from the ADA surface treatment with an impressive gain of 60 mV over the blank. In addition, the EQE values obtained with the AD and ADA treated samples are slightly higher than those of the reference cell in line with the measured photocurrents (see Figure 4C). The projected *J_{sc}* values fit well with the measured ones showing that any spectral mismatch between our simulator and the standard AM 1.5 emission is negligibly small. From Figure 4D, the reference and the AD treated films show practically stable power output over the 60 second tracking time corresponding to 19.12 and 20.35 mW/cm², respectively. Conversely, the ADA modulated perovskite solar cell shows an additional small rise in the output power until reaching a plateau corresponding to a stabilized PCE of 21.3 %. We infer from these measurements that the ADA surface treatment boosts the power conversion efficiency of our triple cation PSC by a remarkable 11.4 %.

**Table 2. Figure of merits of perovskite solar cells before and after passivation**

| Sample | *V_{oc}* (V) | *J_{sc}* (mA/cm²) | *FF* (%) | PCE (%) | Hysteresis index (%) |
|---|---|---|---|---|---|
| Reference-forward | 1.081 | 22.43 | 78.1 | 19.01 | 1.65 |
| Reference-backward | 1.083 | 22.47 | 79.2 | 19.32 | |
| Passivation with AD-forward | 1.139 | 22.48 | 78.4 | 20.11 | 1.73 |
| Passivation with AD-backward | 1.142 | 22.53 | 79.3 | 20.47 | |
| Passivation with ADA-forward | 1.154 | 22.61 | 79.1 | 20.63 | 1.43 |
| Passivation with ADA-backward | 1.155 | 22.57 | 80.4 | 20.93 | |

| | | | | | |
|---|---|---|---|---|---|
| * Note that the intensity of light was 0.998 sun in this measurement. | | | | | |

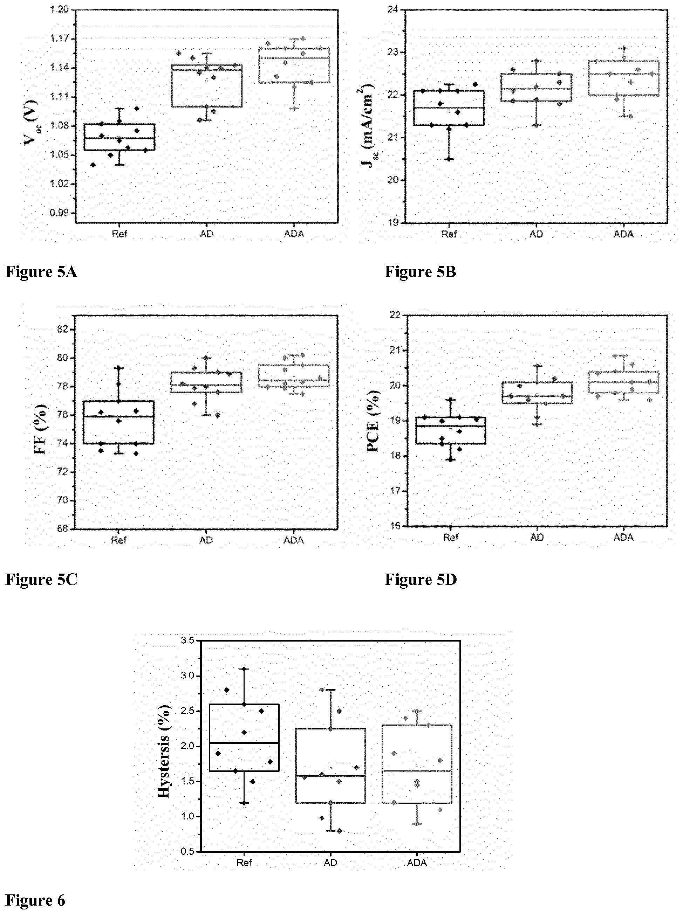

In order to ascertain the reproducibility of the effects resulting from surface modification of the perovskite by the adamantanes we produced 30 devices, *i.e.* 10 for each category and checked the statistical variation of their PV parameters. Figure 5 shows the PV metrics obtained from the *J- V* curves of these cells. The results confirm the beneficial effect exerted by the surface treatment by AD and ADA on all the PV parameters the most striking being the enhancement of the *V_{oc}.* In addition, the results suggest that ADA is more effective in passivating the surface states of perovskite films than AD. We attribute this to stronger surface attachment of the ADA by virtue of its amine group that can anchor to the perovskite surface by replacing an A-cation or by filling an A cation vacancy. The presence of latter defects is undesirable as they act as hole traps immobilizing positively charged carriers at the interface between the perovskite and the spiro-OMeTAD. This enhances carrier recombination and causes hysteresis effects in the *J-V* curves because the trapped carriers produce a net local electric field that causes ion migration in the perovskite films.

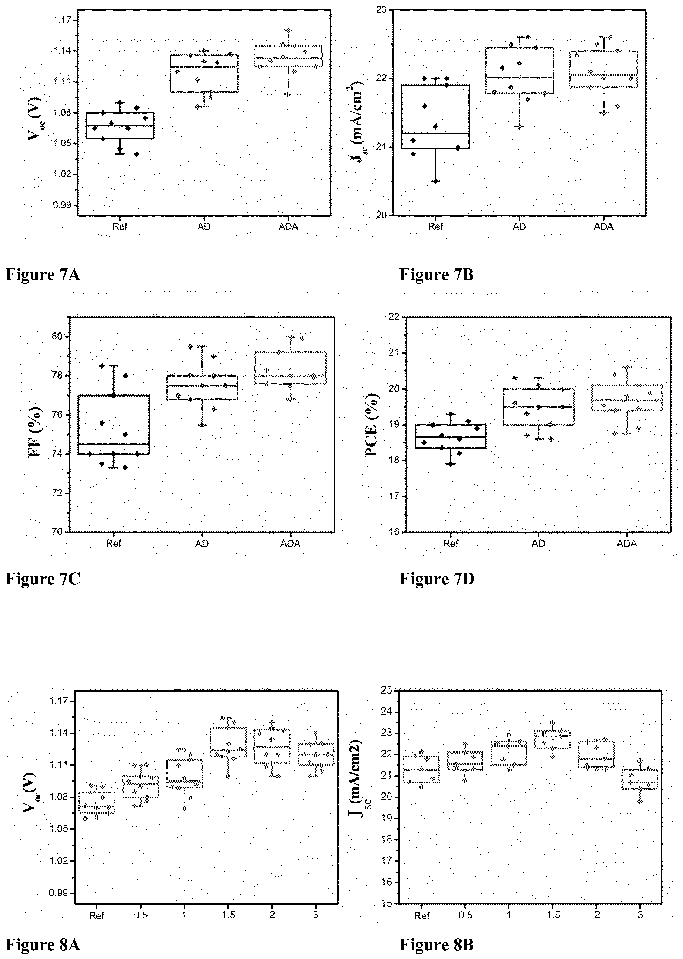

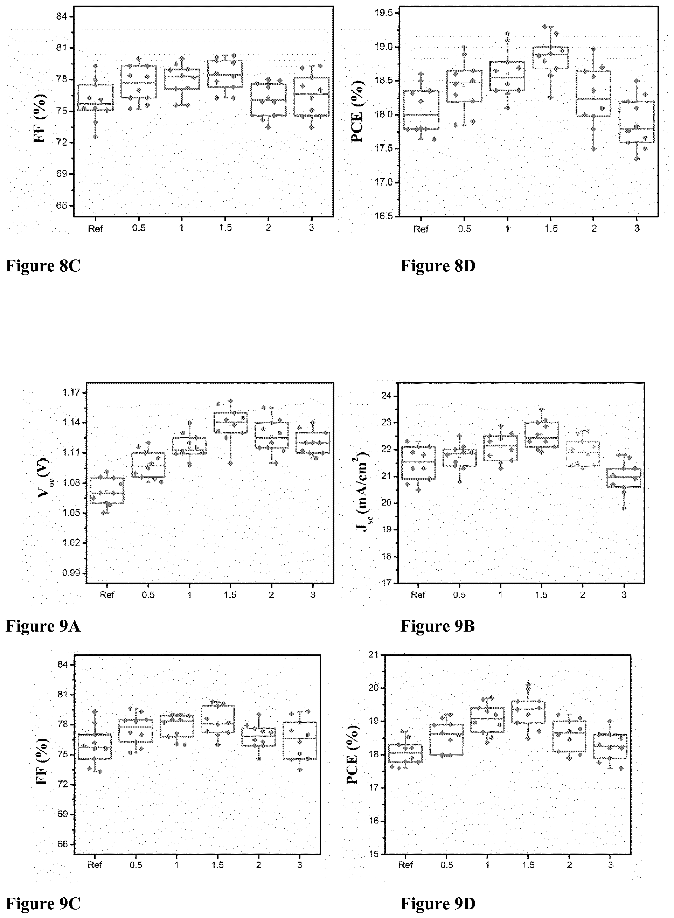

The hysteresis indexes (h) of the passivated devices and reference cell were calculated from the formula h = 100 × (PCE_{backward} - PCE _{folward})/PCE_{backward}. As shown in Figure 6, the hysteresis indexes of passivated devices are slightly lower than that of the reference cell. Figure 7 demonstrates the histograms of the photovoltaic metrics of PSCs passivated with AD and ADA by using the antisolvent (AS) technique. From these measurements, the AS treatment produces smaller performance benefits than spin coating the agents onto the perovskite surface (see Figures 7A-D). In order to identify the optimal concentration of AD and ADA in the spin coating solvent we varied their content from 0 to 3 mg in 1 mL chlorobenzene and present the photovoltaic parameters of devices treated by these solutions (see Figures 8A-D and Figures 9A-D). The data show that the best results are achieved for both additives with a concentration of 1.5 mg/mL.

The contact angle of water on top of the reference sample and the films passivated by AD and ADA was measured (see Figures 10A-C) and obtained the values of 35°, 56°, and 68°, respectively. Thus the films after passivation with AD or ADA have lower wettability by water molecules, protecting the perovskite film from water ingression which should enhance their stability. We confirmed that the passivation of perovskite films with AD and ADA molecules does improve the device stability. We first examined the sensitivity of PSCs to humid air by placing unsealed devices for 3 months in an air box with 20 % relative humidity. The result of this stability test is shown in Figure 10D The perovskite whose surface was passivated with AD and ADA maintained 95% and 98% of their initial values, respectively, while the reference cell showed a 16% PCE loss. We subsequently exposed perovskite films on glass with and without surface passivation by the adamantanes to ambient atmosphere for 1 week. The color of reference sample turned from black to yellow, indicating decomposition of perovskite film under formation of PbI₂. By contrast, the perovskite film passivated with ADA maintained its black colour while the one modified with AD discolored slightly (see Figure 11, XRD patterns of the perovskite films). According to Figure 11, the intensity of the PbI₂ peak located at 12.8° clearly depicts the decomposition of perovskite film under high humidity environment, which is the highest for reference sample.

The operational stability of the devices was examined by exposing them to continuous full-sun illumination under maximum power point tracking in a nitrogen atmosphere at T=30 °C. Figure 10E illustrates that devices treated with ADA and AD by the SP method retained 96% and 92% of their initial values after 300 h under continuous light illumination, respectively, while the reference sample incurred a 28% performance loss. Our investigations clearly show that the introduction of adamantanes as interfacial layers between the perovskite film and the hole conductor is beneficial for both the performance and operational stability of state of the art perovskite solar cells.

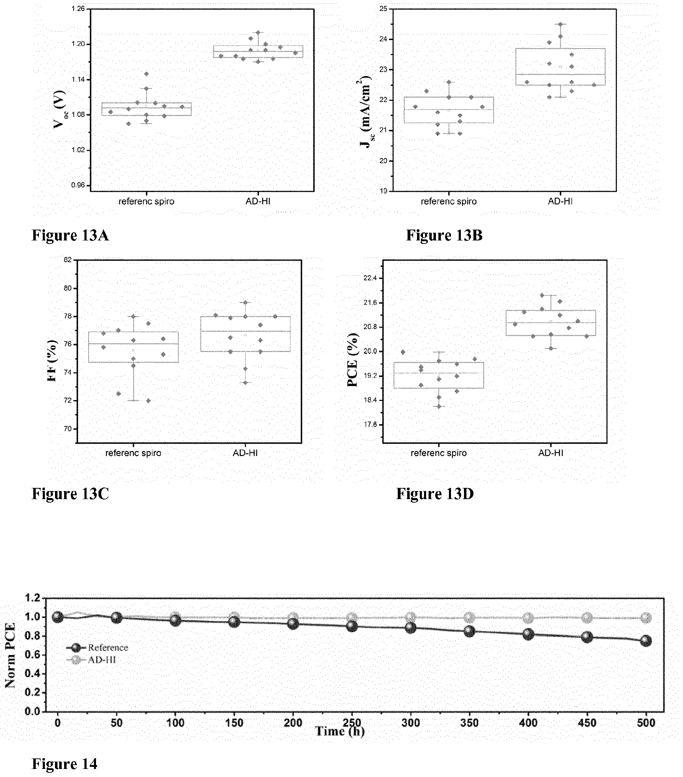

Figure 12 shows the *J- V* curves of triple cations perovskite solar cells based on reference and in-situ passivated device with ADHI. As we optimized the concentration of additive for passivation in Figures 5 and 7, we have added the optimum amount of this additive into the HTL solution. As seen, by using this technique, all *J-V* parameters, especially *V_{oc}* are improved drastically, resulting in power conversion efficiency (PCE) of 21.85% compared with reference sample (19.65%). Table 3 summarizes the photovoltaic parameters of these devices with different scan directions. As seen, the device based on modified HTL shows high PCE with negligible hysteresis as well. The statistical data for 12 devices with and without HTL doping are shown in Figures 13A-D. The results clearly indicate that the average values of all photovoltaic parameters are improved using our new passivation technique. Interestingly, using this technique the average value of V_{oc} is increased by 100 mV.

In order to study the role of ADHI on operational stability of perovskite solar cell, we have performed stability test under continuous light illumination for 500 h. As shown in Figure 14, the modified HTL-based device retains more than 99% of its initial values, while the reference sample shows 25% PCE loss. After checking top-view SEM images of spiro-OMeTAD layers with and without ADHI additive, we discovered that modified spiro-OMeTAD does not have any pinhole and the film is very uniform, while the reference spiro-OMeTAD has many pinholes which can decrease the operational stability of device.

**Table 3. Figure of merits for reference cell and device with in-situ passivation using ADHI.**

| Sample | V_{oc} (V) | J_{sc} (mA/cm²) | FF (%) | PCE (%) | Hysteresis (%) |
|---|---|---|---|---|---|
| Reference-forward | 1.076 | 22.92 | 74.5 | 18.72 | 4.7 |
| Reference - backward | 1.093 | 23.1 | 75.6 | 19.65 | |
| ADHI-spiro-forward | 1.153 | 24.25 | 76.8 | 21.52 | 0.44 |
| ADHI-spiro-backward | 1.155 | 24.28 | 77.2 | 21.85 | |

As show in Figure 13, we observe a remarkably high V_{oc} which indicates suppressed interfacial recombination upon employing the additive in spiro-OMeTAD. To quantify losses due to non-radiative recombination, we performed an optoelectronic analysis of the devices. We measured the open-circuit voltage at 20 °C without mask under LED light. The data in Fig. 15a shows a maximum value of 1.245, which is a record for lead-iodide based perovskite solar cells. However, the real figure of merit is the so-called voltage deficit as defined as difference between the bandgap/e and the measured V_{oc}. We use the IPCE onset represented in a Tauc plot (Fig. 16) to determine the bandgap. We find a value of 1.61 eV, which is lower compared to e.g. the Rb containing CsMAFA perovskite¹⁰, because the composition used here is Cs_{0.05}MA_{0.15}FA_{0.85}Pb(I_{0.85}Br_{0.15})₃.

Hence, the voltage deficit is as low as 365 mV, which is the lowest value reported for any solution processed solar cell (Table 4). Such a low value should come along with high luminescence yields under open circuit conditions. To quantify this yield, we measured electroluminescence (EL), applying a constant current to the solar cell, which is kept in the dark and operated as an LED. The external quantum efficiency of EL reaches 2.5% for a driving current density similar to the short circuit current density (22.5 mA/cm²) (c). This translates into a non-radiative loss as low as 94 meV, clearly surpassing the so far reported record value of 120 meV. Using the reciprocity between absorption and emission, we determine a maximum theoretical V_{oc} of 1.343 V. This value is consistent with the experimental data and the non-radiative losses. Also, the predicted PL peaking at 1.61 matches the measured EL spectrum shown in Fig. 15d. Interestingly, the EL reaches its maximum value after minutes. This is considerably slower to what is reported for non-modified HTL and indicates that applying a forward voltage reduces non-radiative losses, possibly because a redistribution of ions leads to a reduction of surface recombination.

**Table 4. Open circuit voltage, electroluminescence, and band gap of device based ADHI modification.**

| | |
|---|---|
| Voc max theory | 1.343 V |
| EL EQE at 20 mA/cm² | 2.5 % |
| Non-rad. loss | 94 mV |
| Voc calculated | 1.249 V |
| Voc measured | 1.245 V |
| Eg | 1.61 eV |
| Eg/e - Voc | 365 mV |
| EL peak eV | 1.61 |
| Eg - EL peak | 0.365 |

### Example 2:

### Crystal defect mitigating agent or passivating agent: 4-tert-butylbenzylamino hydroiodide (4-TBBHI)

### Synthesis of 4-tert-butylbenzylamino hydroiodide (4-TBBHI).

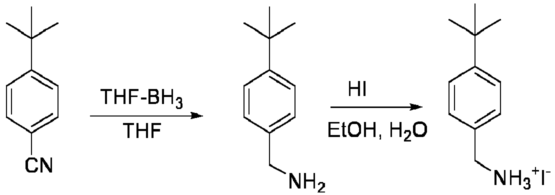

To a solution of 4-*tert*-butyl benzonitrile (10 mmol) was added borane-tetrahydrofuran complex (1M in THF, 40 mL, 40 mmol) under protection of argon. The organic phase was extracted with diethyl ether and dried over sodium sulfide. The organic solvent was removed under reduced pressure, the residue is re-dissolved into 10 mL of *tert*-butanol and cooled to 0 °C under argon protection. Hydroiodide aqueous solution (53% w/w, 15 mmol) was added dropwise into the solution and the reaction mixture was allowed to stir and 0 °C for 3 h. Upon completion of the reaction, the solvent was removed under reduced pressure. The residue brownish solid was washed with diethyl ether spontaneously until the solid become white and clean. The white solid was dried under vacuum to get the final product as white crystal plate.

### Crystal defect mitigating agent or passivating agent 4-methoxy benzylamino hydroiodide. (4-MBHI)

### Synthesis of 4-methoxy benzylamino hydroiodide. (4-MBHI).

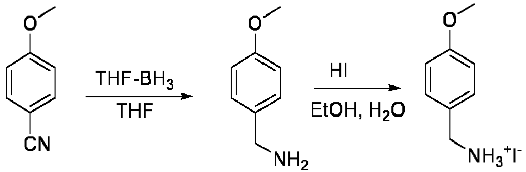

To a solution of *p*-hydroxy benzonitrile (8 mmol) and K₂CO₃ (10 mmol) in ethanol was added methyl iodide dropwise under argon protection. The reaction mixture was allowed to reflux overnight. The solution was filtered and the filtrate solvent was removed under reduced pressure. The residue is re-dissolved into THF and treated with borane-tetrahydrofuran complex (1M in THF, 30 mL, 30 mmol) under protection of argon. The mixed solution was allowed to reflux overnight before quenched with water. The organic phase was extracted with diethyl ether and dried over sodium sulfate. The organic solvent was removed under reduced pressure, the residue is re-dissolved into 10 mL of *tert*-butanol and cooled to 0 °C under argon protection. Hydroiodide aqueous solution (53% w/w, 10 mmol) was added dropwise into the solution and the reaction mixture was allowed to stir and 0 °C for 3 h. Upon completion of the reaction, the solvent was removed under reduced pressure. The residue brownish solid was washed with diethyl ether spontaneously until the solid become white and clean. The white solid was dried under vacuum to get the final product as white powder.

### Device fabrication and power conversion efficiency

50 mg 4-*tert*-butylbenzylamino hydroiodide or 4-methoxy benzylamino hydroiodide was dissolved into 1 mL of acetonitrile as stock solution. To 1 mL of spiro-OMeTAD solution (contain 90 mg spiro-OMeTAD, 35.5 µL *tert*-butyl pyridine, 10.5 mg of LiTFSI) was added 60 µL of the stock solution. The as-prepared mixed spiro-OMeTAD solution was casted onto the perovskite active layer.

**Table 5. Figure of merits for reference cell and device with in-situ passivation using 4-TBBHI or 4-MBHI.**

| **Photovoltaic Device** | ***V*_{OC (V)}** | ***J*_{SC (mA Cm-²)}** | ***FF*** | **PCE (%)** |
|---|---|---|---|---|
| Reference | 1.121 | 23.55 | 0.781 | 20.6 |
| With 4-TBBHI | 1.161 | 23.53 | 0.805 | 22.0 |
| With 4-MBHI | 1.125 | 23.20 | 0.801 | 20.9 |

In a conclusion, the benzyl based amino iodide additives exhibit significant improvement to the fill factor of the perovskite solar cell devices. In both cases the fill factors could be higher than 80%. Compared to the control devices, the additive modified devices show similar current. Devices with 4-TBBHI, the open-circuit voltage has increased by 40 mV, while with 4-MBHI, the open-circuit voltage is similar to the control devices. Devices based with the alkyl benzyl amines show better passivation effect to the perovskite layer compared to the alkoxy benzyl amines.

## Claims

1. An optoelectronic and/or photovoltaic device comprising a compound used as crystal defect mitigating agent or passivating agent, said compound being selected from a compound of formula (I) 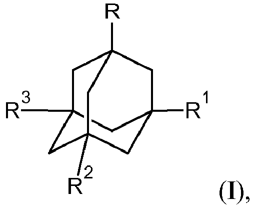 a compound of formula (II) 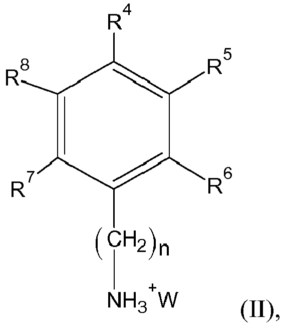 a mixture thereof, or
a compound of formula (III) being a compound of formula (I), of which substituent R is substituted by one compound of formula (II) being linked to said compound of formula (I) through any one of unsubstituted R⁴, R⁵, R⁶, R⁷ or R⁸, and wherein the substituent R⁴, R⁵, R⁶, R⁷ or R⁸ not being linked are independently selected from any substituent as defined below,
wherein
R, R¹, R², R³, R⁴, R⁵, R⁶, R⁷ and R⁸ are independently selected from H, -NH₂, -NCS, - CN, - NCO, -NH₃⁺, -NH₃⁺Y, -R⁹ -NHR⁹, -NR⁹R¹⁰, -O-R⁹, -S-R⁹, or halogen being selected from F, Cl, Br or I, wherein R⁹ and R¹⁰ are independently selected from C6-C15 aryl, C6-C15 heteroaryl, C3-C15 cycloalkyl group, C3-C15 heterocycloalkyl groups, C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein aryl, heteroaryl, cycloalkyl, heterocycloalkyl, alkyl, heteroalkyl, alkenyl, alkynyl group are unsubstituted or further substituted by halogen being selected from F, Cl, Br or I,
Y and W are independently selected from F⁻, Cl⁻, Br⁻, I⁻, SCN⁻, BF₄⁻, PF₆⁻, ClO₄⁻, N(SO₂CF₃)₂⁻, N(SO₂CF₂CF₃)₂⁻, CH₃SO₃⁻, CF₃SO₃⁻, CF₃COO⁻, BPh₄, C(SO₂CF₃)₃⁻, NCS⁻, CN⁻, NCO⁻, and
n is an integer from 0, 1 to 5.

2. The optoelectronic and/or photovoltaic device according to claim 1, wherein the compound used as crystal defect mitigating agent or passivating agent is selected from a compound of formula (I) or a compound of formula (III).

3. The optoelectronic and/or photovoltaic device according to any one of the preceding claims, wherein R¹, R², and R³ of the compound of formula (I) or of the compound of formula (III) are H.

4. The optoelectronic and/or photovoltaic device according to any one of the preceding claims, wherein R of the compound of formula (I) is selected from H, -NH₂, -NH₃⁺, -NH₃⁺Y, -R⁹, -NHR⁹, -NR⁹R¹⁰, -O-R⁹, -S-R⁹, or halogen being selected from F, Cl, Br or I, wherein R⁹ and R¹⁰ are independently selected from C6-C15 aryl, C6-C15 heteroaryl, C3-C15 cycloalkyl group, C3-C15 heterocycloalkyl groups, C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein aryl, heteroaryl, cycloalkyl, heterocycloalkyl, alkyl, heteroalkyl, alkenyl, alkynyl group are unsubstituted or further substituted by halogen being selected from F, Cl, Br or I, and wherein Y is selected from F⁻, Cl⁻, Br⁻, I⁻, SCN⁻, BF₄⁻, PF₆⁻, ClO₄⁻, N(SO₂CF₃)₂⁻, N(SO₂CF₂CF₃)₂⁻, CH₃SO₃⁻, CF₃SO₃⁻, CF₃COO⁻, BPh₄⁻, C(SO₂CF₃)₃⁻.

5. The optoelectronic and/or photovoltaic device according to any one of the preceding claims, wherein R of the compound of formula (I) is selected from H, -NH₂, -NH₃⁺, -NH₃⁺Y, wherein Y is selected from F⁻, Cl⁻, Br⁻, I⁻, SCN⁻, BF₄⁻, PF₆⁻, ClO₄⁻, N(SO₂CF₃)₂⁻, N(SO₂CF₂CF₃)₂⁻, CH₃SO₃, CF₃SO₃⁻, CF₃COO⁻, BPh₄⁻, C(SO₂CF₃)₃.

6. The optoelectronic and/or photovoltaic device according to claim 1, wherein the compound used as crystal defect mitigating agent or passivating agent is selected from a compound of formula (II).

7. The optoelectronic and/or photovoltaic device according to any one of the preceding claims, wherein R⁵, R⁶, R⁷ and R⁸ of the compound of formula (II) or, if present, of the compound of formula (III) are H and n is an integer from 1 to 5.

8. The optoelectronic and/or photovoltaic device according to any one of the preceding claims, wherein R⁴ of the compound of formula (II) or, if present, of the compound of formula (III), is selected from H, R⁹, -NHR⁹, -NR⁹R¹⁰, -O-R⁹, -S-R⁹, or halogen, wherein R⁹ and R¹⁰ are independently selected from C3-C15 cycloalkyl group, C3-C15 heterocycloalkyl groups, C1-C15 alkyl group, C1-C15 heteroalkyl group, C2-C15 alkenyl group, C2-C15 alkynyl group, wherein one or more heteroatoms are selected from N, S or O, wherein said alkyl, heteroalkyl, alkenyl and alkynyl group, if they comprise 3 or more carbons, may be linear, branched or cyclic and wherein cycloalkyl, heterocycloalkyl, alkyl, heteroalkyl, alkenyl, alkynyl group are unsubstituted or further substituted by halogen being selected from F, Cl, Br or I; and n is an integer from 1 to 5.

9. The optoelectronic and/or photovoltaic device according to any one of the preceding claims further comprising a light-harvesting layer comprising a metal organohalide perovskite and a hole transport layer comprising a hole transport material, wherein the compound used as crystal defect mitigating agent or passivating agent is infiltrated in the light-harvesting layer and/or coats the top of the light-harvesting layer forming a layer being a passivation layer and/or is included into the hole transport layer, and wherein the hole transport layer is in electric contact with the light-harvesting layer and/or the passivation layer.

10. The optoelectronic and/or photovoltaic device according to claim 9 further comprising a conducting support layer, n-type semiconductor, an electron transport layer and a back contact, wherein the n-type semiconductor is in electric contact with the conducting support layer and the electron transport layer is in electric contact with the n-type semiconductor; and the back contact is in electric contact with the hole transport layer.

11. The optoelectronic and/or photovoltaic device according to any one of claims 9-10, wherein the metal organohalide perovskite is selected from a perovskite structure according to any one of formulae (I), (Ia), (Ib), (Ic), (Id), (Ie), (If) and/or (Ig) below:
| | |
|---|---|
| AA'MX₄ | (I) |
| AMX₃ | (Ia) |
| AA'N_{2/3}X₄ | (Ib) |
| AN_{2/3}X₃ | (Ic) |
| BN_{2/3}X₄ | (Id) |
| BMX₄ | (Ie) |
| (Aₗ)ₘAA'MX₃ | (If) |
| (Aₗ)ₘAMX₃ | (Ig) |
wherein,
- A and A' are organic, monovalent cations being independently selected from primary, secondary, tertiary or quaternary organic ammonium compounds, including N-containing heterorings and ring systems, A and A' having independently from 1 to 60 carbons and 1 to 20 heteroatoms;
- A₁ is an inorganic cation selected from Cs⁺, Rb⁺, K⁺ and m is an integer from 1 to 3, each A₁ if m >1 being different;
- B is an organic, bivalent cation selected from primary, secondary, tertiary or quaternary organic ammonium compounds having from 1 to 60 carbons and 2-20 heteroatoms and having two positively charged nitrogen atoms;
- M is selected from Cu2⁺, Ni²⁺, Co²⁺, Fe,²⁺ Mn²⁺, Cr²⁺, Pd²⁺, Cd²⁺, Ge²⁺, Sn²⁺, Pb²⁺, Eu²⁺, Yb²⁺, [SnᵢPb₍₁₋ᵢ₎]⁺, [SnⱼGe₍₁₋ⱼ₎]⁺, and [PbₖGe₍₁₋ₖ₎]⁺, i, j and k being a number between 0.0 and 1.0;
- N is selected from the group of Bi³⁺ and Sb³⁺; and,
- X are independently selected from Cl⁻, Br⁻, I⁻, NCS⁻, CN⁻, NCO⁻, from [I₍₃₋ₒ₎Clₒ]⁻, [I₍₃₋ₚ₎Brₚ]⁻, [Br₍₃₋ᵤ₎Clᵤ]⁻, o, p and u being a number between 0.0 and 3.0, and from a combination of two anions selected from Cl⁻, Br⁻, I⁻.

12. The optoelectronic and/or photovoltaic device according to any one of claims 9-11, wherein the hole transport material is selected from semiconductor particles comprising NiO, CuO, CuSCN, CuI, CuGaO₂, CuCrO₂ or CuAlO₂ or any combination thereof or from triphenylamine, carbazole, N,N,(diphenyl)-N',N'di-(alkylphenyl)-4,4'-biphenyldiamine, (pTPDs), diphenylhydrazone, poly [N,N'-bis(4-butylphenyl)-N,N'-bis(phenyl)benzidine] (polyTPD), polyTPD substituted by electron donor groups and/or acceptor groups, poly(9,9-dioctylfluorene-alt-N-(4-butylphenyl)-diphenylamine (TFB), 2,2',7,7'-tetrakis-N,N-di-p-methoxyphenylamine-9,9'-spirobifluorene) (spiro-OMeTAD), N,N,N',N'-tetraphenylbenzidine (TPD), PTAA (Poly[bis(4-phenyl)(2,4,6-trimethylphenyl)amine]).

13. The optoelectronic and/or photovoltaic device according to any one of claims 10-12, wherein the electron transport layer comprises an amorphous metal oxide layer.

14. The optoelectronic and/or photovoltaic device according to any one of the preceding claims is selected from an organic photovoltaic device, a photovoltaic solid state device, a p-n heterojunction, a metal organohalide perovskite photovoltaic device, a metal organohalide perovskite solar cell, a solid state solar cell, a phototransistor or LED (light-emitting diode).

15. The optoelectronic and/or photovoltaic device according to any one of the preceding claims is selected from an organic photovoltaic device, a photovoltaic solid state device, a p-n heterojunction, a metal organohalide perovskite photovoltaic device, a metal organohalide perovskite solar cell, or a solid state solar cell.
